(19) Europäisches Patentamt
European Patent Office
Office européen des brevets

(11) **EP 1 720 179 B1**

(12) **EUROPÄISCHE PATENTSCHRIFT**

(45) Veröffentlichungstag und Bekanntmachung des Hinweises auf die Patenterteilung:
**26.09.2012 Patentblatt 2012/39**

(51) Int Cl.:
***G01R 33/3815*** *(2006.01)*

(21) Anmeldenummer: **06009103.0**

(22) Anmeldetag: **03.05.2006**

(54) **Magnetanordnung mit Vorrichtung zum Dämpfen von Spannungsspitzen einer Speisung und Verfahren zum Betrieb derselben**

Magnet assembly with means for the attenuation of voltage peaks of a power supply and method for operating the magnet assembly

Ensemble magnétique ayant un dispositif pour reduire les pics de tension d'un alimentation et methode d'operation d'un tel ensemble

(84) Benannte Vertragsstaaten:
**CH DE FR GB LI**

(30) Priorität: **03.05.2005 DE 102005020690**

(43) Veröffentlichungstag der Anmeldung:
**08.11.2006 Patentblatt 2006/45**

(73) Patentinhaber: **Bruker BioSpin AG**
**8117 Fällanden (CH)**

(72) Erfinder:
• **Spreiter, Rolf, Dr.**
**8050 Zürich (CH)**
• **Schauwecker, Robert**
**8004 Zürich (CH)**

(74) Vertreter: **Kohler Schmid Möbus**
**Patentanwälte**
**Ruppmannstraße 27**
**70565 Stuttgart (DE)**

(56) Entgegenhaltungen:
**DE-A1- 3 926 204    DE-A1- 10 065 400**
**US-A- 3 577 067    US-A1- 2003 057 942**

• **STINY, L.: "Grundwissen Elektrotechnik" 2000, FRANZIS' VERLAG , XP009100560 * Seite 245 - Seite 248 * * Seite 255; Abbildung 194 ***
• **BERNAT T P ET AL: "Automated flux pump for energizing high current superconducting loads" REVIEW OF SCIENTIFIC INSTRUMENTS, AIP, MELVILLE, NY, US, Bd. 45, Nr. 5, 1. Mai 1975 (1975-05-01), Seiten 582-585, XP007904624 ISSN: 0034-6748**

**Beschreibung**

Die Erfindung betrifft eine Magnetanordnung mit einem supraleitenden Magnetspulensystem, welches ein Arbeitsvolumen und im Betriebszustand einen ohmschen Widerstand größer oder gleich Null aufweist, und mit mindestens einem Strompfad, welcher mindestens Teile des Magnetspulensystems umfasst, mit Anschlusspunkten, einer Speisung und mit mindestens einem elektrischen Netzwerk, wobei die Anschlusspunkte des Strompfades mit netzabgewandten Anschlüssen mindestens eines elektrischen Netzwerkes und die Speisung mit netzseitigen Anschlüssen des elektrischen Netzwerks elektrisch verbunden sind, und wobei das Netzwerk mindestens einen Widerstand aufweist, wobei die netzabgewandten Anschlüsse miteinander über mindestens den Widerstand verbunden sind.

Eine derartige Magnetanordnung ist aus US 2003/0057942 A1 bekannt.

Magnetanordnungen mit einem supraleitenden Magnetspulensystem werden insbesondere für Magnetresonanzmessungen (NMR) benötigt. Hierbei wird eine große Stabilität des Feldes gefordert.

Supraleitende Magnetsysteme für hochauflösende NMR werden normalerweise im "persistent" Modus betrieben, das heißt der Stromkreis ist kurzgeschlossen, so dass keine aktive Speisung mehr nötig ist, sobald der Magnet einmal geladen ist. Damit die Magnetdrift (Stromabnahme pro Zeit) genügend klein ist, werden sehr hohe Anforderungen an die Drähte und Drahtverbindungen bezüglich Restwiderstand gestellt.

Supraleitende Drähte besitzen keinen scharfen Übergang zwischen supraleitendem und normal leitendem Zustand. Werden die Drähte stark belastet resultiert ein ohmscher Widerstand größer Null für das Magnetspulensystem. Dies ist insbesondere für Hochfeldmagnete und insbesondere bei Verwendung von Hochtemperatursupraleitern der Fall. In diesen Fällen ist ein persistent Modus mit der geforderten Stabilität entweder nicht mehr möglich oder unwirtschaftlich und man benötigt eine Methode um diese resistiven Verluste zu kompensieren.

Um diese resistiven Verluste der Magnetspule auszugleichen, ist es bekannt, Speisungen zu verwenden, die Energie in die Magnetspule einkoppeln. Derartige Speisungen werden auch zum Laden oder Entladen von Magnetspulen verwendet.

Aus US 2003/0057942 A1 ist eine Magnetanordnung mit einem supraleitenden Magnetspulensystem und einer konventionellen Stromquelle als Speisung bekannt. Zur Dämpfung der durch die unzureichende Stabilität der Stromquelle in den Magneten gelangenden Stromschwankungen sieht die bekannte Vorrichtung ein Netzwerk mit einem zum Magneten parallel geschalteten Widerstand vor. Diese Art der Dämpfung führt jedoch nur bei einer kontinuierlichen Stromzuführung mittels einer konventionellen Stromquelle zur gewünschten Dämpfung. Bei Verwendung von konventionellen Stromquellen als Speisung entsteht allerdings, aufgrund der großen Ströme, die in den Kryostaten geführt werden müssen, ein großer Wärmeeintrag in den Kryostaten, der einen stabilen Betrieb der Magnetanordung erschwert.

Der Wärmeeintrag in den Kryostaten kann durch die Verwendung von Flusspumpen als Speisungen reduziert werden. Dabei wird induktiv Energie in die Magnetspule des Magnetspulensystems eingekoppelt. Für den Einsatz zur präzisen Feldstabilisierung über große Zeiträume sind Flusspumpen jedoch bislang nicht geeignet, da die von der Flusspumpe generierte Ladespannung normalerweise zeitlich nicht konstant ist. Beim Öffnen der Schalter können zudem Spannungsspitzen auftreten und bei den meisten Verfahren gibt es auch Unterbrechungen und periodische Schwankungen in der generierten Spannung. Diese Störungen und periodisch schwankenden Spannungen, welche sich dann in Feldschwankungen des Magnetsystems äußern, sind für empfindliche Anwendungen wie hochauflösende Magnetresonanzverfahren nicht tolerierbar, da sie hochauflösende NMR-Messungen erschweren oder sogar unmöglich machen können.

Eine Magnetanordnung mit einem supraleitenden Magnetspulensystem und einer Speisung (Flusspumpe) ist bekannt aus US3'150'291 und T. P. Bemart et al., Rev. Sci. Instrum., Vol. 46, No. 5, May 1975, Seiten 582- 585, sowie L.J.M. van de Klundert et al., Cryogenics, April 1981, Seiten 195- 206.

Aus L. Stiny "Grundwissen Elektrotechnik", Poing, Franzis Verlag GmbH, 2000, sind RL- und RC-Glieder zur Verwendung als Spannungsfilter bekannt.

US 3 577 067 A offenbart ist eine Magnetanordnung, welche im Netzwerk einen RC-Tiefpass verwendet.

Aufgabe der vorliegenden Erfindung ist es, eine Magnetanordnung mit einem supraleitenden Magnetspulensystem und einer Speisung (z.B. Flusspumpe) gemäß dem Stand der Technik vorzuschlagen, die eine verbesserte Dämpfung der durch die Speisung in den Magneten gelangenden Feldschwankungen realisiert, so dass, trotz der erwähnten Fluktuationen in der generierten Spannung, die effektiv über dem Magneten anliegende Spannung in dem Maße konstant ist, dass beispielsweise hochauflösende NMR-und MRI-Verfahren nicht gestört werden.

Erfindungsgemäß wird diese Aufgabe dadurch durch eine Magnetanordnung gemäß Patentanspruch 1 gelöst.

Das Netzwerk umfasst erfindungsgemäß mindestens eine Induktivität, wobei die netzseitigen Anschlüsse miteinander über mindestens den Widerstand und die Induktivität verbunden sind.

Diese Anordnung bewirkt, dass Spannungsänderungen von der Speisung geglättet werden und praktisch ein konstanter Mittelwert der Spannung über dem Magneten anliegt, so dass zum Beispiel hochauflösende NMR-Messungen durchgeführt werden können. Die Glättung der schwankenden Energieeinspeisung erfolgt dadurch, dass Energie in den supraleitenden Spulen zwischengespeichert wird und dann langsam und bei entsprechender Auslegung praktisch kontinuierlich, an das Magnetsystem abgegeben wird. Das Netzwerk, welches die Speisung mit dem Magnetsystem verbindet, wirkt dabei wie ein Tiefpassfilter.

Darüber hinaus können auch Spannungsspitzen sehr effektiv gedämpft werden. Dies hat zur Folge, dass die Bauart der verwendeten Speisung unerheblich ist. Die erfindungsgemäße Anordnung stellt demnach eine Verbesserung für alle Ausführungsformen von Speisungen dar.

Die Induktivität des Netzwerks wird erfindungsgemäß von einer supraleitenden Spule gebildet. Bei supraleitenden Spulen fallen keine zusätzlichen Verluste an, die von der Speisung ausgeglichen werden müssten. Außerdem lassen sich mit supraleitenden Spulen große Zeitkonstanten und damit eine bessere Filterwirkung erzielen.

Die Speisung der erfindungsgemäßen Magnetanordnung ist eine Flusspumpe. Mit Hilfe der vorliegenden Erfindung ist es erstmals möglich, eine Flusspumpe als aktive Speisung zum Beispiel für ein hochauflösendes NMR-System einzusetzen, da die fast unvermeidlichen Spannungsspitzen so stark geglättet werden, dass sie nicht mehr stören. Dies ermöglicht die Entwicklung von stärkeren und kompakteren Magnetsystemen.

Eine bevorzugte Ausführungsform der erfindungsgemäßen Magnetanordnung sieht vor, dass mindestens zwei Netzwerke zwischen den Anschlusspunkten des Strompfades und der Speisung derart geschaltet sind, dass die netzabgewandten Anschlüsse des ersten Netzwerks an den netzseitigen Anschlüssen des zweiten Netzwerks angeschlossen sind, wobei das zweite Netzwerk mindestens eine Induktivität umfasst und die netzabgewandten Anschlüsse miteinander über mindestens einen Widerstand des zweiten Netzwerks und die netzseitigen Anschlüsse miteinander über mindestens den Widerstand und die Induktivität verbunden sind. Die Filterwirkung lässt sich durch eine entsprechende Anzahl an Netzwerken im Prinzip so weit erhöhen, bis die Spannungsschwankungen keinen störenden Einfluss auf die Messungen mehr haben.

Bei einer Ausführungsform der Magnetanordnung ist die Speisung eine aktive Stromquelle (driven mode). Die erfindungsgemäße Anordnung wirkt dann stabilisierend, das heißt Schwankungen der Stromquelle können so stark gedämpft werden, so dass zum Beispiel empfindliche NMR-Messungen nicht mehr gestört werden.

Es ist vorteilhaft, wenn mindestens eine der Induktivitäten mindestens eines der Netzwerke vom Magnetspulensystem weitgehend induktiv entkoppelt ist. Dies kann durch entsprechende räumliche Anordnung der Spulen erreicht werden. Dadurch wird eine Übertragung von Störungen in den Magneten durch induktive Einkopplung vermieden.

Weiterhin ist es von Vorteil, wenn mindestens eine der Induktivitäten mindestens eines der Netzwerke derart angeordnet ist, dass ihr Streufeld im Arbeitsvolumen minimiert wird. Dadurch wird eine Störung, durch das zeitlich nicht ganz konstante Streufeld der Spulen, zum Beispiel der empfindlichen NMR-Messungen, vermieden.

Eine spezielle Ausführungsform der erfindungsgemäßen Magnetanordnung sieht vor, dass mindestens eine der Induktivitäten mindestens eines der Netzwerke eine Spule umfasst, die eine Abschirmwicklung besitzt, so dass ihr Streufeld minimiert wird. Die Abschirmwicklung reduziert das Streufeld und auch die Empfindlichkeit der gesamten Anordnung auf äußere magnetische Störungen, so dass Störungen durch Stromschwankungen in der Spule vermieden werden können.

Beim Vorhandensein von mindestens zwei Netzwerken ist es von Vorteil wenn mindestens zwei der Induktivitäten jeweils mindestens eine Spule umfassen, welche räumlich so angeordnet sind, dass ihr Gesamtfeld im Arbeitsvolumen minimiert wird. Durch die gegenseitige Kompensation der Streufelder der einzelnen Spulen kann das totale Streufeld klein gehalten werden, so dass die Magnetanordnung weniger empfindlich auf äußere Störungen ist.

Vorzugsweise ist die Zeitkonstante L/R des Netzwerks in der gleichen Größenordnung oder größer als die Periodendauer der größten Schwankungsamplitude der Spannung oder des Stroms der Speisung. In diesem Bereich lässt sich eine genügende Glättung und brauchbare Dämpfung von Störungen erreichen.

Bei einer vorteilhaften Ausführungsform der erfindungsgemäßen Magnetanordnung ist zu mindestens dem Widerstand des Netzwerks ein Schalter in Serie geschaltet. Durch Öffnen des Schalters wird die Dämpfung außer Betrieb gesetzt. Dies kann beim Laden oder Entladen nötig sein, da sonst zu große Ströme über die Widerstände im Netzwerk fließen würden. Durch diese Ausschaltmöglichkeit der Filterelemente wird auch das Einstellen der Parameter einer Flusspumpe als Spannungsquelle stark vereinfacht.

Bei einer besonders vorteilhaften Ausführungsform der erfindungsgemäßen Magnetanordnung wird der Schalter außerhalb des Kryostaten im Raumtemperaturbereich angeordnet. Dadurch kann ein Filterelement deaktiviert werden, ohne dass ein größerer Wärmeeintrag in den Kryostaten erfolgt.

Vorzugsweise ist der Schalter ein supraleitender Schalter. Durch die Verwendung eines supraleitenden Schalters zum deaktivieren eines Filterelementes sind, wenn der Schalter geschlossen ist, sehr kleine Widerstände im Filterelement möglich und es können mit kleinen Spulen große Filterzeitkonstanten realisiert werden.

Bei einer weiteren vorteilhaften Ausführungsform der erfindungsgemäßen Magnetanordnung ist zu mindestens dem Widerstand des Netzwerks ein supraleitender Strombegrenzer in Serie geschaltet. Der supraleitende Strombegrenzer wird anstatt eines Schalters zum deaktivieren eines Filterelementes verwendet. Wird der Strom zu groß, z.B. beim Laden des Magnetsystems, sind die Filterelemente automatisch deaktiviert, ohne dass zusätzliche Leitungen in den Kryostaten geführt werden müssen.

Die erfindungsgemäße Anordnung ist besonders dann vorteilhaft, wenn das supraleitende Magnetspulensystem Teil einer Apparatur für magnetische Kemspinresonanz ist. In solchen Magnetanordnungen werden an eine Vorrichtung zur aktiven Feldstabilisierung besonders hohe Anforderungen hinsichtlich Konstanz der Stabilisierungsspannung und Minimierung des Wärmeeintrages in den Kryostaten gestellt. Genau diese Kriterien werden in der oben aufgeführten Anordnung von Flusspumpe mit Filternetzwerk und supraleitendem Magnetsystem besser erfüllt als mit Anordnungen nach dem Stand der Technik.

Bei einer besonders vorteilhaften Ausführungsform der erfindungsgemäßen Magnetanordnung umfasst das supraleitende Magnetspulensystem eine oder mehrere Spulen aus Hochtemperatursupraleiter. Die potentiell höhere Drift bei Verwendung von Hochtemperatursupraleitem lässt sich unter Beibehaltung der Feldstabilität des supraleitenden Magnetspulensystems mit der erfindungsgemäßen dämpfend wirkenden Anordnung und einer Flusspumpe kompensieren.

Zum Betrieb einer zuvor beschriebenen Magnetanordnung kann ein Verfahren verwendet werden, bei dem zum Laden des supraleitenden Magnetspulensystems mindestens der supraleitende Schalter des Netzwerks geheizt wird, um zu vermeiden, dass zu große Querströme durch die Widerstände fließen und zu viel Wärme erzeugt wird.

Vorzugsweise wird der erregende Strom der Speisung so eingestellt, dass die durch den Widerstand des Magnetsystems verursachte Magnetdrift weitgehend kompensiert wird, insbesondere so, dass der Strom der Speisung größer als der Strom im Strompfad P ist.

Ebenso ist es vorteilhaft, wenn eine von der Speisung zeitlich variierende oder gepulste Spannung so eingestellt wird, dass ihr zeitlicher Mittelwert die durch den Widerstand des Magnetsystems verursachte Drift weitgehend kompensiert. Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1 ein Verdrahtungsschema einer erfindungsgemäßen Magnetanordnung mit einer Flusspumpe als Speisung;

Fig. 2 ein Verdrahtungsschema einer erfindungsgemäßen Magnetanordnung mit einer Flusspumpe als Speisung und zwei erfindungsgemäßen Netzwerken;

Fig. 3 ein Verdrahtungsschema eines erfindungsgemäßen Netzwerks mit einem Schalter; und

Fig. 4 ein Verdrahtungsschema eines erfindungsgemäßen Netzwerks mit einem supraleitenden Strombegrenzer.

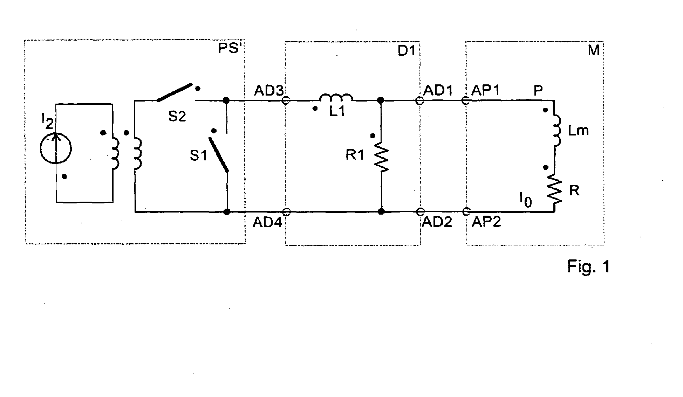

Anhand der **Fig. 1** wird schematisch eine erfindungsgemäße Anordnung gezeigt, welche ein supraleitendes Magnetspulensystem **M** mit einer supraleitenden Spule **Lm**, eine Speisung **PS'** und ein erfindungsgemäßes Netzwerk **D1** zur Dämpfung von Spannungsspitzen umfasst. Das Magnetspulensystem M weist einen Widerstand **R** auf, der in dem Verdrahtungsschema als Ersatzwiderstand eingezeichnet ist. Über Anschlusspunkte **AP1, AP2** eines Strompfads **P** und über das Netzwerk D1 ist das Magnetspulensystem M mit der Speisung PS' verbunden, die dem Magnetspulensystem M, über das Netzwerk D1 einen Strom **I1** zuführt. Die Anbindung des Netzwerks D1 an die Speisung PS' erfolgt hierbei über Anschlüsse **AD3, AD4** des Netzwerkes D1.

Das Netzwerk D1 umfasst eine Induktivität **L1** und einen Widerstand **R1**. Die netzabgewandten Anschlüsse **AD1, AD2** des Netzwerks D1 sind miteinander über den Widerstand R1 verbunden, wohingegen die netzseitigen Anschlüsse AD3, AD4 miteinander über den Widerstand R1 und die Induktivität L1 verbunden sind. Durch diese erfindungsgemäße Ausgestaltung des Netzwerks D1 wird es ermöglicht, dass während der schwankenden Energieeinspeisung der Speisung PS' Energie in der Induktivität L1 zwischengespeichert wird und dann kontinuierlich an das Magnetsystem abgegeben wird, so dass eine zeitlich konstantere Energieeinspeisung in das Magnetspulensystem M realisiert wird.

Bei der Speisung PS' handelt es sich erfindungsgemäß um eine Flusspumpe, welche Schalter **S1, S2** umfasst. Die Flusspumpe generiert im Betrieb eine periodisch schwankende Spannung über den Anschlusspunkten AD3 und AD4 des Netzwerkes D1 mittels periodischen Variationen des Stromes **I2.** Darüber hinaus entstehen durch das Betätigen der Schalter S1, S2 Spannungsspitzen. Das erfindungsgemäße Netzwerk D1 glättet diese Spannung, so dass praktisch nur noch der zeitliche Mittelwert der Spannung über dem Magnetspulensystem M anliegt. Die nichtkontinuierliche Spannung der Flusspumpe wird mittels der durch das Netzwerk D1 bewirkten Dämpfung so stark gefiltert, dass die über dem Magnetsystem M anliegende Spannung eine so gute Konstanz aufweist, dass mit der erfindungsgemäßen Anordnung beispielsweise empfindliche Kemspinresonanzexperimente durchgeführt werden können.

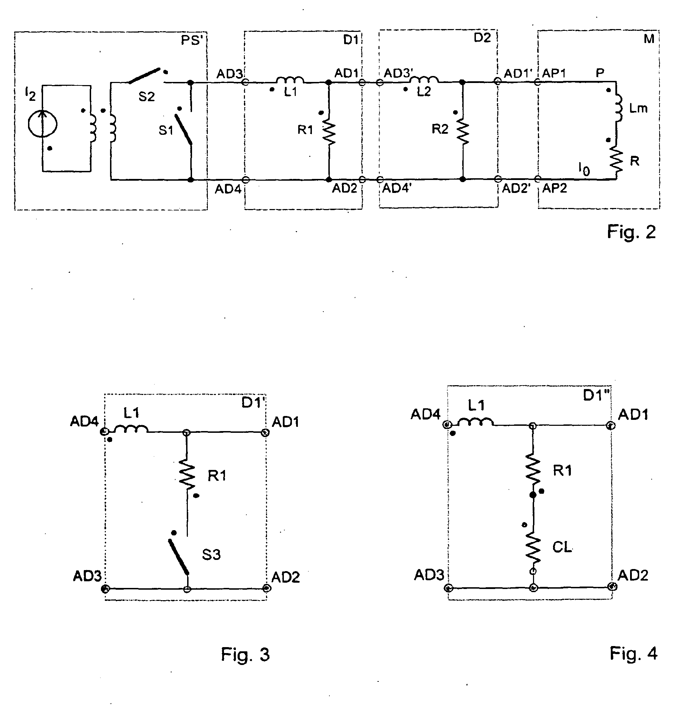

**Fig. 3** zeigt eine Ausführungsform des erfindungsgemäßen Magnetspulensystems mit einem weiteren Netzwerk **D2**, welches in Serie mit dem Netzwerk D1 geschaltet ist. Die netzabgewandten Anschlüsse AD1, AD2 des ersten Netzwerks D1 sind dabei an netzseitigen Anschlüssen **AD3'**, **AD4'** des zweiten Netzwerks D2 angeschlossen, wobei netzabgewandte Anschlüsse **AD1', AD2'** des Netzwerks D2 miteinander über einen Widerstand **R2** des zweiten Netzwerks D2 und die netzseitigen Anschlüsse AD3', AD4' über den Widerstand R2 und eine Induktivität **L2** miteinander verbunden sind. Durch eine derartige Serienschaltung zweier oder auch mehrerer Netzwerke D1, D2 lässt sich die Dämpfungseigenschaft der Gesamtanordnung verstärken.

**Fig. 4** zeigt eine Ausführungsform eines erfindungsgemäßen Netzwerks **D1'**. Das Netzwerk D1' weist einen Schalter **S3** auf. Durch Öffnen des Schalters S3 kann die Filterfunktion des Netzwerks D1' ausgeschaltet werden. Dies ist beispielsweise zum Laden und Entladen der Magnetanordnung M notwendig und vereinfacht das Einstellen der Parameter einer Flusspumpe als Speisung PS'.

**Fig. 5** zeigt eine Ausführungsform eines erfindungsgemäßen Netzwerks **D1"**. Das Netzwerk D1" weist einen supraleitenden Strombegrenzer **CL** auf. Steigt der Strom durch den Strombegrenzer CL über einen bestimmten Schwellenwert, wird er hochohmig und das Filterelement deaktiviert. Dies verhindert hohe Ströme im Filterelement während des Ladens und Entladens des Magneten.

Im Folgenden wird die Erfindung anhand eines Beispiels erläutert.

Es wird ein NMR-Magnet mit einer Feldstärke, welche einer Protonenresonanzfrequenz $f_0 = 600\,\text{MHz}$ entspricht, einem Magnetstrom von $I_0 = 130\,\text{A}$ und mit einer Induktivität von $L = 150$ Henry betrachtet. Der Magnet sei leicht resistiv, was eine Drift von $d = 0.306\,\text{Hz/s}$ bewirke. Um diese Drift zu kompensieren wird eine Stützspannung von

$$U_s = d\,\frac{L I_0}{f_0} = 10\;\mu\text{V}\quad\text{benötigt.}$$

Ideal wäre eine Speisung, welche dauernd diese konstante Spannung generiert. Reale Flusspumpen arbeiten jedoch zyklisch und generieren normalerweise periodische Spannungen. Für das Beispiel nehmen wir an, dass eine Flusspumpe mit einer Periode von 600 s arbeitet, wobei sie während der halben Zeit eine Spannung von 20 μV generiert und die restliche Zeit für ihre Regeneration braucht.

Nach dem Stand der Technik, ohne die erfinderische Dämpfung, wird der Magnet während der Stützphase mit + 0.306 Hz/s "geladen" um dann während der Regenerationsphase mit - 0.306 Hz/s zu driften. Im langfristigen Mittel bleibt das Feld dann zwar konstant, über einen Zyklus wird die Magnetfrequenz aber um 92 Hz variieren, was für hochauflösende NMR-Spektroskopie nicht akzeptabel ist.

Es wird im Folgenden gezeigt, wie mit der Dämpfung durch die Anordnung der erfindungsgemäßen Netzwerke die Schwankung der Magnetfrequenz über einen Zyklus der Flusspumpe auf einen für hochauflösende NMR akzeptablen Wert von < 0.1 Hz reduziert werden kann.

Die dem Beispiel zu Grunde gelegte Ausführungsform der erfindungsgemäßen Anordnung entspricht im Prinzip der Fig. 3, weist jedoch anstatt zwei vier in Serie geschaltete Netzwerke D1, D2, D3, D4 auf. Der Einfachheit halber sollen für das Beispiel die vier Induktivitäten L1, L2, L3, L4 und die vier Widerstände R1, R2, R3, R4 der vier Netzwerke D1, D2, D3, D4 jeweils gleich sein:

$$L1 = L2 = L3 = L4 = L$$

$$R1 = R2 = R3 = R4 = R$$

Die Schaltung lässt sich am einfachsten im Frequenzraum analysieren. Für den Betrag der Spannungsübertragungsfunktion im Frequenzraum erhalten wir in komplexer Schreibweise und mit $\tau = L/R$:

$$\left|F(\omega)\right| = \left|\frac{U_a}{U_e}(\omega)\right| = \frac{1}{\left|1 - 10 i\tau\omega - 15\tau^2\omega^2 + 7 i\tau^3\omega^3 + \tau^4\omega^4\right|} \qquad (1)$$

Da die von der Flusspumpe erzeugte Spannung $U_e(t)$ periodisch ist mit Periodendauer T, kann sie als Fourierreihe dargestellt werden:

$$U_e(t) = \frac{a_0}{2} + \sum_{n=1}^{\infty}\left(a_k \cos n\omega t + b_k \sin n\omega t\right). \qquad (2)$$

$a_0/2 = 10\,\mu V$ ist der zeitliche Mittelwert der von der Flusspumpe erzeugten Spannung, der im stationären Zustand gemäß Formel (1) ohne Abschwächung übertragen wird. Die größte Fourierkomponente ist die der Frequenz $\omega = 2\pi/T$ und hat die Amplitude:

$$U_{p,\omega} = 2a_0/\pi = 12.73\,\mu V$$

Die Fourierkomponente $U_{p.\omega}$ bewirkt eine Schwankungsamplitude in der Magnetfrequenz von:

$$f_\omega = \frac{f_0 U_{p.\omega}}{\hat{I}_0 \omega L}.$$

Für die Anwendung der hochauflösenden Kernspinresonanz ist eine maximale Schwankung des Feldes von 0.1 Hz tolerierbar, dass heißt: $0.1\ \mathrm{Hz} > \dfrac{f_0 U_{p.\omega}}{I_0 \omega L} F(\omega)$ und damit $F(\omega) < 2.67 \times 10^{-3}$

Mit Formel (1) folgt dann für die Filterzeitkonstante: $\tau > 2340s$. Eine solch lange Zeitkonstante kann mit z.B. einer supraleitenden Spule von 10 mH und einem Widerstand von 4.3 $\mu\Omega$ realisiert werden.

Anhand dieses Beispiels einer erfindungsgemäßen Magnetanordnung werden die Vorteile bezüglich der Filterwirkung der elektrischen Netzwerke im Zusammenhang mit der Verwendung einer Flusspumpe als Speisung deutlich.

Obwohl die von der Flusspumpe generierte Spannung stark schwanken kann, ist es mit der erfindungsgemäßen Magnetanordnung dennoch möglich, die effektiv über dem Magneten anliegende Spannung so konstant zu halten. Es wird eine verbesserte Dämpfung der Strom- und Spannungsschwankungen der Speisung PS' realisiert, so dass im Strompfad (P) ein ausreichend konstanter der Strom $I_0$ fließt, dass beispielsweise hochauflösende NMR-und MRI-Verfahren nicht gestört werden.

**Bezugszeichenliste**

| | |
|---|---|
| AD1, AD2 | netzabgewandte Anschlüsse des ersten Netzwerks |
| AD1', AD2' | netzabgewandte Anschlüsse des zweiten Netzwerks |
| AD3, AD4 | netzseitige Anschlüsse des ersten Netzwerks |
| AD3', AD4' | netzseitige Anschlüsse des zweiten Netzwerks |
| AP1, AP2 | Anschlusspunkte des Strompfads |
| D1, D1', D1" | erstes Netzwerk |
| D2 | zweites Netzwerk |
| I1, I2 | Strom der Speisung |
| $I_0$ | Strom im Strompfad P |
| L1 | Induktivität des ersten Netzwerks |
| L2 | Induktivität des zweiten Netzwerks |
| Lm | supraleitenden Spule |
| M | Magnetspulensystem |
| P | Strompfad |
| PS, PS' | Speisung |
| R | Widerstand des Magnetspulensystems |
| R1 | Widerstand des ersten Netzwerks |
| R2 | Widerstand des zweiten Netzwerks |
| S1 | Schalter der Flusspumpe |
| S2, S3 | Schalter im Netzwerk |
| CL | supraleitender Strombegrenzer |

**Patentansprüche**

1. Magnetanordnung mit einem supraleitenden Magnetspulensystem (M), welches ein Arbeitsvolumen und im Betriebszustand einen ohmschen Widerstand (R) größer oder gleich Null aufweist, und mit mindestens einem Strompfad (P), welcher mindestens Teile des Magnetspulensystems (M) umfasst, mit Anschlusspunkten (AP1, AP2), einer Speisung (PS') und mit mindestens einem elektrischen Netzwerk (D1, D1', D1", D2), wobei die Anschlusspunkte (AP1, AP2) des Strompfades (P) mit netzabgewandten Anschlüssen (AD1, AD2, AD1', AD2') mindestens eines elektrischen Netzwerkes (D1, D1', D1", D2), und die Speisung (PS') mit netzseitigen Anschlüssen (AD3, AD4) des elektrischen Netzwerks (D1, D1', D1 ") elektrisch verbunden sind, und wobei das Netzwerk (D1, D1', D1") mindestens einen Widerstand (R1) aufweist, wobei die netzabgewandten Anschlüsse (AD1, AD2, AD1 AD2') miteinander über mindestens den Widerstand (R1, R2) verbunden sind,
**dadurch gekennzeichnet,**
**dass** das Netzwerk (D1, D1', D1", D2) mindestens eine Induktivität (L1, L2) umfasst, und die netzseitigen Anschlüsse (AD3, AD4) miteinander über mindestens den Widerstand (R1, R2) und die Induktivität (L1, L2) verbunden sind,
**dass** die Induktivität (L1, L2) des Netzwerks (D1, D1', D1", D2) von einer supraleitenden Spule gebildet wird, und dass die Speisung (PS') eine Flusspumpe ist..

2. Magnetanordnung nach Anspruch 1, **dadurch gekennzeichnet, dass** mindestens zwei Netzwerke (D1, D1', D1", D2) zwischen den Anschlusspunkten (AP1, AP2) des Strompfades (P) und der Speisung (PS') derart geschaltet sind, dass die netzabgewandten Anschlüsse (AD1, AD2) des ersten Netzwerks (D1, D1', D1") an den netzseitigen Anschlüssen (AD3', AD4') des zweiten Netzwerks (D2) angeschlossen sind, wobei das zweite Netzwerk (D2) mindestens eine Induktivität (L2) umfasst und die netzabgewandten Anschlüsse (AD1', AD2') miteinander über mindestens einen Widerstand (R2) des zweiten Netzwerks (D2) und die netzseitigen Anschlüsse (AD3', AD4') miteinander über mindestens den Widerstand (R2) und die Induktivität (L2) verbunden sind.

3. Magnetanordnung nach einem der vorangehenden Ansprüche, **dadurch gekennzeichnet, dass** die Zeitkonstante (L1/R1) des Netzwerks (D1, D1', D1") in der gleichen Größenordnung oder größer als die Periodendauer der größten Schwankungsamplitude der Spannung oder des Stromes (I1, I2) der Speisung (PS') ist.

4. Magnetanordnung nach einem der vorangehenden Ansprüche, **dadurch gekennzeichnet, dass** zu mindestens dem Widerstand (R1) des Netzwerks (D1') ein supraleitender Schalter (S3) in Serie geschaltet ist.

**Claims**

1. Magnet configuration with a superconducting magnet coil system (M)
comprising a working volume and an ohmic resistance (R) of zero or more during operation, and with at least one current path (P) which
includes at least parts of the magnet coil system (M), with connecting points (AP1, AP2), a power supply (PS') and at least one electric network (D1, D1', D1", D2), wherein the connecting points (AP1, AP2) of the current path (P) are electrically connected to connections (AD1, AD2, AD1', AD2') of at least one electric network (D1, D1', D1", D2) facing away from the power supply, and the power supply (PS') is electrically connected to connections (AD3, AD4) on the power supply side of the electric network (D1, D1', D1"), and wherein the network (D1, D1', D1") comprises at least one resistance (R1), wherein the connections (AD1, AD2, AD1', AD2') facing away from the power supply are connected to each other via at least the resistance (R1, R2),
**characterized in that**
the network (D1, D1', D1", D2) comprises at least one inductance (L1, L2), and the connections (AD3, AD4) on the power supply side are connected to each other via at least the resistance (R1, R2) and the inductance (L1, L2), the inductance (L1, L2) of the network (D1, D1', D1", D2) is formed by a superconducting coil and the power supply (PS') is a flux pump.

2. Magnet configuration according to claim 1, **characterized in that** at least two networks (D1, D1', D1", D2) are connected between the connecting points (AP1, AP2) of the current path (P) and the power supply (PS') in such a manner that the connections (AD1, AD2) of the first network (D1, D1', D1") facing away from the power supply, are connected to the connections (AD3', AD4') on the power supply side of the second network (D2), wherein the second network (D2) comprises at least one inductance (L2) and the connections (AD1', AD2') facing away from the power supply, are connected to each other via at least one resistance (R2) of the second network (D2), with the connections (AD3', AD4') on the power supply side being connected to each other via at least the resistance (R2) and the inductance (L2).

3. Magnet configuration according to any one of the preceding claims, **characterized in that** the time constant (L1/R1) of the network (D1, D1', D1") is on the same order of magnitude or larger than the time duration of the largest fluctuation amplitude of the voltage or current (I1, I2) of the power supply (PS').

4. Magnet configuration according to any one of the preceding claims, **characterized in that** a superconducting switch (S3) is connected in series to at least the resistance (R1) of the network (D1').

**Revendications**

1. Agencement magnétique avec un système de bobines magnétiques supraconductrices (M) qui présente un volume de travail et une résistance ohmique (R) supérieure ou égale à zéro dans l'état de fonctionnement, et avec au moins un trajet de courant (P), lequel comprend au moins des parties du système de bobines magnétiques (M), avec des points de connexion (AP1, AP2), une alimentation (PS') et avec au moins un réseau électrique (D1, D1', D1", D2), les points de connexion (AP1, AP2) du trajet de courant (P) étant reliés électriquement à des connexions éloignées du réseau (AD1, AD2, AD1', AD2') d'au moins un réseau électrique (D1, D1', D1", D2), et l'alimentation (PS') à des connexions côté réseau (AD3, AD4) du réseau électrique (D1, D1', D1"), et le réseau (D1, D1', D1") présentant au moins une résistance (R1), les connexions éloignées du réseau (AD1, AD2, AD1', AD2') étant reliées entre elles par au moins la résistance (R1, R2),
   **caractérisé en ce**
   **que** le réseau (D1, D1', D1", D2) comprend au moins une inductance (L1, L2) et les connexions côté réseau (AD3, AD4) sont reliées entre elles par au moins la résistance (R1, R2) et l'inductance (L1, L2),
   **que** l'inductance (L1, L2) du réseau (D1, D1', D1", D2) est formée par une bobine supraconductrice, et que l'alimentation (PS') est une pompe à flux.

2. Agencement magnétique selon la revendication 1, **caractérisé en ce qu'**au moins deux réseaux (D1, D1', D1", D2) sont montés entre les points de connexion (AP1, AP2) du trajet de courant (P) et l'alimentation (PS') de façon que les connexions éloignées du réseau (AD1, AD2) du premier réseau (D1, D1', D1") soient connectées aux connexions côté réseau (AD3', AD4') du deuxième réseau (D2), le deuxième réseau (D2) comprenant au moins une inductance (L2) et les connexions éloignées du réseau (AD1', AD2') étant reliées entre elles par au moins une résistance (R2) du deuxième réseau (D2) et les connexions côté réseau (AD3', AD4') entre elles par au moins la résistance (R2) et l'inductance (L2).

3. Agencement magnétique selon une des revendications précédentes, **caractérisé en ce que** la constante de temps (L1/R1) du réseau (D1, D1', D1") est du même ordre de grandeur ou plus grande que la durée de période de la plus grande amplitude de fluctuation de la tension ou du courant (I1, I2) de l'alimentation (PS').

4. Agencement magnétique selon une des revendications précédentes, **caractérisé en ce qu'**un commutateur supraconducteur (S3) est monté en série avec au moins la résistance (R1) du réseau (D1').

Fig. 1

Fig. 2

Fig. 3

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030057942 A1
- US 3150291 A
- US 3577067 A

**In der Beschreibung aufgeführte Nicht-Patentliteratur**

- **T. P. Bemart et al.** *Rev. Sci. Instrum.,* Mai 1975, vol. 46 (5), 582-585
- **L.J.M. van de Klundert et al.** *Cryogenics,* April 1981, 195-206